# FASCICULE DE BREVET EUROPEEN

(11) **EP 0 665 588 B1**
(45) Date de publication et mention de la délivrance du brevet: **07.04.1999**
(21) Numéro de dépôt: 95400148.3
(22) Date de dépôt: 24.01.1995
(51) Int. Cl.: H01L 21/76, H01L 21/20

(54) **Procédé de dépôt de lames semiconductrices sur un support**
Abscheidungsverfahren von Halbleiterschichten auf einem Träger
Deposition process of semiconductor layers on a support

(30) Priorité: 26.01.1994 FR 9400836
(43) Date de publication de la demande: 02.08.1995
(73) Titulaire: COMMISSARIAT A L'ENERGIE ATOMIQUE, 75015 Paris (FR)
(72) Inventeur: Bruel, Michel, F-38113 Veurey (FR)
(74) Mandataire: Dubois-Chabert, Guy

(56) Documents cités:
- EP-A- 0 533 551
- PATENT ABSTRACTS OF JAPAN vol. 7, no. 107 (E-174) 11 Mai 1983 & JP-A-58 030 145 (SONY KK) 22 Mars 1983
- S.M. Sze, "VLSI Technology", Mcgraw-Hill, 1983, p.250-252

## Description

La présente invention concerne un procédé de dépôt d'une ou de plusieurs lames semiconductrices sur un support et en particulier sur un support isolant.

Dans beaucoup de dispositifs à commande électronique, on est amené à déposer des composants semiconducteurs de surface restreinte par rapport à la surface de l'élément qui les supporte. Il en est ainsi par exemple dans les écrans plats de visualisation à matrice active où chaque élément d'image de l'écran (ou pixel) est commandé par un transistor. Les techniques actuellement mises en oeuvre pour ce genre de dispositif utilisent du silicium amorphe hydrogéné ou du silicium polycristallin pour la réalisation des transistors de commande des pixels.

Au cours de la réalisation de ces transistors, toute la surface du support sur lequel sont élaborés les pixels est recouverte d'une couche de matériau semiconducteur amorphe ou polycristallin selon le cas. Ensuite on dégage par gravure la plus grande partie de cette couche pour ne laisser que les zones réservées aux transistors. La surface occupée par les transistors de commande ne représente qu'une faible part de la surface du pixel (inférieure à 20%). On cherche de toute façon à réduire cette occupation parasite ainsi que celles des interconnexions pour que la perte de transmission lumineuse de l'écran soit minimum.

Cette méthode traditionnelle de réalisation des transistors de commande des pixels provoque donc le gaspillage de la majeure partie de la couche de silicium déposée initialement. Jusqu'à maintenant on n'attachait pas trop d'importance à ce fait parce que le coût de dépôt d'une couche de silicium amorphe ou polycristallin est faible. Ceci n'est plus vrai si l'on veut employer un matériau semiconducteur de qualité supérieure et en particulier le silicium monocristallin. Dans ce cas le gaspillage de la majeure partie de la couche de silicium devient un inconvénient sérieux.

La présente invention permet d'apporter une solution à ce problème. Elle offre la possibilité de déposer un matériau semiconducteur, notamment du silicium monocristallin, sous forme de petites lames déposées juste aux endroits nécessaires et dont la surface est juste suffisante pour la réalisation des dispositifs. On obtient ainsi un procédé techniquement très performant, puisqu'il permet l'utilisation de silicium monocristallin, et peu coûteux car très économe en silicium. En outre, ce procédé s'applique aux écrans à matrice active de très grande surface.

Le procédé selon la présente invention met en oeuvre une technique dérivée de l'enseignement du document FR-A-2 681 472. Ce document divulgue un procédé de fabrication de films minces de matériau semiconducteur comprenant trois étapes. Dans une première étape, on réalise par implantation une couche de microbulles gazeuses sous une face d'une plaquette de matériau semiconducteur, par bombardement ionique. Dans une seconde étape, la face de la plaquette est rendue solidaire d'un raidisseur. Dans une troisième étape, l'ensemble constitué par la plaquette et le raidisseur est soumis à une température suffisante pour créer, par effet de réarrangement cristallin dans la plaquette et de pression dans les microbulles, un clivage de la plaquette au niveau de la couche de microbulles. On obtient ainsi un film mince adhérant au raidisseur.

L'invention a donc pour objet un procédé de dépôt d'au moins une lame semiconductrice d'épaisseur et d'étendue déterminées sur un support, comprenant les étapes suivantes :
- bombardement par des ions d'une face d'un substrat semiconducteur pour créer une couche de microbulles gazeuses selon un plan de clivage du substrat, l'énergie d'implantation des ions étant prévue pour obtenir la couche de microbulles gazeuses à une profondeur correspondant à l'épaisseur déterminée de la lame semi-conductrice, les ions étant choisis parmi les ions de gaz rares ou de gaz hydrogène,
- solidarisation sur ladite face du substrat du support,
- traitement thermique afin d'induire dans la couche de microbulles gazeuses une température suffisante pour provoquer ledit clivage,
caractérisé en ce que l'étape de traitement thermique est réalisé au moyen d'un faisceau lumineux éclairant de manière sélective une zone de ladite face du substrat, au travers du support qui est transparent à ce faisceau lumineux, pour induire adiabatiquement ladite température dans une région de la couche de microbulles gazeuses correspondant à la lame semiconductrice à déposer, le faisceau lumineux provoquant également l'augmentation de l'adhésion du support sur ladite face du substrat dans ladite zone traversée par le faisceau lumineux, cette étape de traitment thermique étant suivie d'une étape de désolidarisation du substrat par rapport au support, cette désolidarisation séparant la lame du substrat et la conservant sur le support dans ladite zone.

On entend par solidarisation toute opération entre le substrat et le support permettant d'assurer une énergie de liaison suffisante entre ces deux éléments pour qu'ils ne se dissocient pas au cours des opérations ultérieures. On peut citer par exemple des opérations de traitement de surface permettant d'engendrer des liaisons interatomiques, des opérations de collage, etc. Par ailleurs, la notion de désolidarisation inclut toute opération de séparation, par exemple par l'exercice d'une traction.

Le procédé peut avantageusement comporter, préalablement ou postérieurement à l'étape de bombardement, une étape de gravure de ladite face du substrat par des tranchées délimitant sur la face du substrat une surface correspondant à l'étendue de ladite lame.

De préférence, la profondeur des tranchées est supérieure à la profondeur de la couche de microbulles gazeuses.

Si le substrat est destiné à fournir plusieurs lames sur le support, l'éclairage des zones de la face du substrat correspondant aux lames à déposer peut être obtenu par balayage du substrat par le faisceau lumineux, ou peut être réalisé de manière collective par éclairage au travers d'un masque percé d'ouvertures correspondant aux zones à éclairer.

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 représente un substrat semiconducteur au cours de l'étape de bombardement ionique conformément au procédé de dépôt selon l'invention,
- la figure 2 illustre l'étape d'éclairage du substrat pour provoquer le clivage de lames du substrat semiconducteur et l'augmentation de leur adhérence sur un support, conformément au procédé de dépôt selon l'invention,
- la figure 3 est une vue de détail du substrat de la figure 2,
- la figure 4 illustre une variante de l'étape d'éclairage, conformémemnt au procédé de dépôt selon l'invention,
- la figure 5 illustre l'étape finale de retrait du substrat par rapport au support du procédé de dépôt selon l'invention.

A titre d'exemple de réalisation, la suite de la description portera sur le dépôt d'un ensemble de lames semiconductrices en silicium monocristallin sur un support en verre destiné à entrer dans la constitution d'un écran plat de visualisation à matrice active.

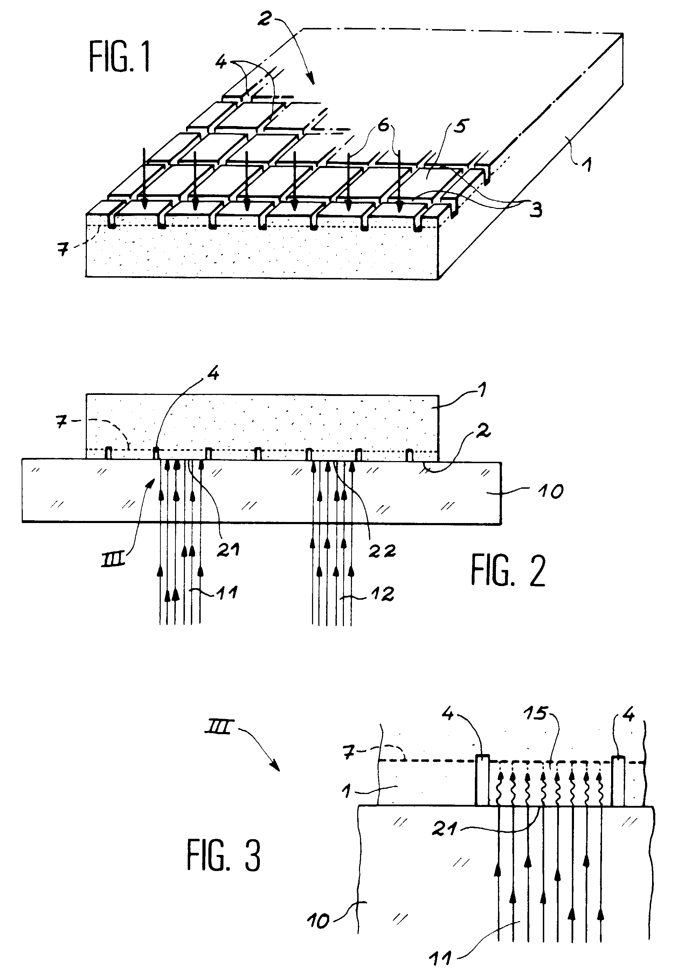

La figure 1 montre un substrat monocristallin 1 en silicium monocristallin utilisé comme source de petites lames minces destinées à être transférées sur le support en verre de l'écran plat. Les lames peuvent avoir une surface de l'ordre de 10 à 40 µm de côté et une épaisseur de l'ordre du µm. Elles peuvent être réparties régulièrement sur la surface du support en verre, selon deux directions orthogonales X et Y, à un pas compris sentre 100 et 1000 µm.

Pour faciliter la séparation des lames semiconductrices du reste du substrat, la face 2 du substrat qui sera soumise au procédé selon l'invention peut être gravée de tranchées 3 tracées selon une première direction coupant des tranchées 4 tracées selon une seconde direction perpendiculaire à la première. Ces tranchées 3 et 4 peuvent avoir par exemple une largeur de 3 µm pour une profondeur de 2 µm. Elles quadrillent la surface du substrat 1 et délimitent entre elles des zones, telle que celle référencée 5 sur la figure 1, de surface correspondant à celle des lames désirées.

Les tranchées 3 et 4 ne sont pas obligatoires mais elles facilitent la séparation des lames de leur substrat et permettent de bien délimiter l'étendue de ces lames. Elles peuvent être réalisées aussi bien avant l'étape d'implantation qu'après celle-ci.

La face 2 du substrat semiconducteur 1 est alors soumise à une étape d'implantation par bombardement de cette face par des ions hydrogène (protons ou H₂⁺), portant la référence générale 6, d'énergie fonction de l'épaisseur de la lame souhaitée. A titre d'exemple, on peut bombarder le substrat 1 par des protons d'énergie 100 keV, ce qui correspond à une épaisseur d'environ 800 nm (8000 angströms). La dose de protons lors du bombardement est de l'ordre de 5 . 10¹⁶ protons/cm² et la température du substrat, pendant l'étape d'implantation, est maintenue entre 150°C et 350°C.

On peut éventuellement utiliser des ions de gaz rare à la place des ions hydrogène, à condition d'adapter les paramètres d'implantation comme l'enseigne le document FR-A-2 681 472 déjà cité.

L'implantation d'ions ainsi réalisée génère une couche de microbulles gazeuses 7 sous la face 2 du substrat semiconducteur 1. Lors de la préparation du substrat, la profondeur des tranchées 3 et 4 a été prévue pour être supérieure à la profondeur de la couche de microbulles gazeuses.

On applique ensuite sur la face 2 du substrat semiconducteur 1 ainsi traitée le support sur lequel seront fixées les lames de semiconducteur. Dans cet exemple de réalisation, ce support est en verre. Il est transparent au faisceau lumineux qui sera mis en oeuvre dans la suite du procédé. Le substrat et le support sont solidaires entre eux par exemple grâce à des liaisons inter-atomiques.

La figure 2 montre une telle disposition où l'on reconnaît le support 10. A travers le support en verre 10, on éclaire alors sélectivement les zones du substrat semiconducteur 1 que l'on veut déposer sur ce support. La figure 2 montre ainsi deux faisceaux lumineux 11 et 12 éclairant respectivement et successivement des zones 21 et 22 de la face 2 du substrat. L'éclairage de ces zones doit satisfaire aux critères suivants : densité de puissance absorbée dans le film de silicium soumis à cet éclairage et durée de l'éclairage tels que la température de la surface éclairée s'élève adiabatiquement au-dessus de 600°C sans que la température des surfaces voisines s'élève. Cette élévation de température des zones éclairées induit alors un clivage à une profondeur correspondant à la profondeur de pénétration des ions hydrogène (c'est-à-dire au niveau de la couche de microbulles) et l'augmentation de l'énergie de liaison entre ces zones et le support grâce à l'accroissement de l'énergie des liaisons inter-atomiques dû à l'élévation de température.

A la figure 3, qui est une vue de détail agrandie de la figure 2, on a représenté par des traits ondulés 15 la propagation de l'élévation de température vers la partie de la couche de microbulles gazeuses 7 comprise entre les deux tranchées 4, pour l'une des zones éclairées.

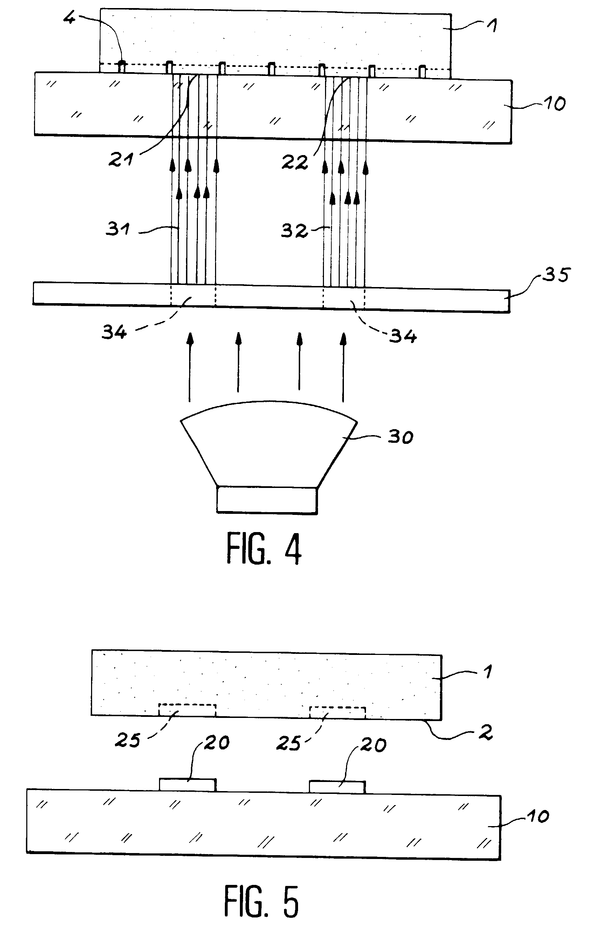

Les faisceaux lumineux peuvent être fournis par un laser YAG. A titre d'exemple, le faisceau lumineux issu du laser YAG, provoquant le clivage d'une lame et l'augmentation de son adhésion sur le support, peut avoir une durée d'impulsion de 30 ns et apporter une énergie de 0,2 à 0,4 J par impulsion. L'éclairage peut être réalisé par balayage pour éclairer successivemenet chaque lame à déposer. Il peut aussi être réalisé collectivement pour déposer toutes les lames simultanément au moyen d'un masque. C'est ce que représente la figure 4 qui reprend l'ensemble substrat semiconducteur 1 - support en verre 10 de la figure 2. Cette fois, les zones 21 et 22 (les seules représentées) sont éclairées simultanément par des faisceaux lumineux respectivement 31 et 32 fournis par une source lumineuse commune 30 et passant par les ouvertures 34 du masque 35. Ces ouvertures 34 peuvent être de surfaces égales à celles des lames à obtenir et réparties selon le même pas.

L'étape suivante, représentée à la figure 5, consiste à écarter le substrat semiconducteur 1 et le support 10 l'un de l'autre. Cela est possible car les parties qui ont été éclairées sont séparées du substrat semicondcuteur et parce que l'énergie de liaison est faible dans les parties qui n'ont pas été éclairées puisque la température n'a pas augmenté. On obtient ainsi un support 10 pourvu, aux emplacements choisis, de lames semiconductrices 20 adhérant au support. Le transfert est ainsi réalisé, la face 2 du substrat 1 présentant des évidements superficiels 25 correspondant aux lames tranférées.

Bien que, par souci de simplification, les figures n'ont représenté que le cas du transfert de deux lames semiconductrices, il est bien entendu que le transfert peut concerner beaucoup plus de lames et, en particulier, toutes les lames semiconductrices nécessaires à la réalisation d'un écran plat à matrice active par exemple.

Après le transfert d'un premier ensemble de lames, le substrat semiconducteur peut être utilisé pour le transfert d'un second ensemble de lames, puis d'un troisième ensemble, etc. On peut procéder de cette manière jusqu'à épuisement de toutes les lames d'une même surface si le substrat semiconducteur a été initialement implanté par des ions de manière uniforme sur toute la surface de transfert. Après cela, la face prélevée du substrat peut être repolie pour une nouvelle application du procédé selon l'invention.

La présente invention peut encore s'appliquer avantageusement à la réalisation de capteurs d'images et de têtes d'impression à matrice active.

## Revendications

1. Procédé de dépôt d'au moins une lame semiconductrice (20) d'épaisseur et d'étendue déterminées sur un support (10), comprenant les étapes suivantes :
- bombardement par des ions (6) d'une face (2) d'un substrat semiconducteur (1) pour créer une couche de microbulles gazeuses (7) selon un plan de clivage du substrat (1), l'énergie d'implantation des ions étant prévue pour obtenir la couche de microbulles gazeuses (7) à une profondeur correspondant à l'épaisseur déterminée de la lame semiconductrice (20), les ions étant choisis parmi les ions de gaz rares ou de gaz hydrogène,
- solidarisation sur ladite face (2) du substrat du support (10),
- traitement thermique afin d'induire dans la couche de microbulles gazeuses (7) une température suffisante pour provoquer ledit clivage,
caractérisé en ce que l'étape de traitement thermique est réalisée au moyen d'un faisceau lumineux éclairant de manière sélective une zone de ladite face du substrat (1), au travers du support (10) qui est transparent à ce faisceau lumineux, pour induire adiabatiquement ladite température dans une région de la couche de microbulles gazeuses correspondant à la lame semiconductrice à déposer, le faisceau lumineux provoquant également l'augmentation de l'adhésion du support (10) sur ladite face du substrat (1) dans ladite zone traversée par le faisceau lumineux, cette étape de traitement thermique étant suivie d'une étape de désolidarisation du substrat (1) par rapport au support (10), cette désolidarisation séparant la lame (20) du substrat et la conservant sur le support dans ladite zone.

2. Procédé selon la revendication 1, caractérisé en ce qu'il comporte, préalablement ou postérieurement à l'étape de bombardement, une étape de gravure de ladite face (2) du substrat (1) par des tranchées (3, 4) délimitant sur la face du substrat une surface correspondant à l'étendue de ladite lame.

3. Procédé selon la revendication 2, caractérisé en ce que la profondeur des tranchées est supérieure à la profondeur de la couche de microbulles gazeuses.

4. Procédé selon l'une quelconque des revendications 1 à 3, caractérisé en ce que, le substrat (1) devant fournir plusieurs lames (20) sur le support (10), l'éclairage des zones de la face du substrat correspondant aux lames à déposer est obtenu par balayage du substrat par le faisceau lumineux (11, 12).

5. Procédé selon l'une quelconque des revendications 1 à 3, caractérisé en ce que, le substrat (1) devant fournir plusieurs lames (20) sur le support (10), l'éclairage des zones (21, 22) de la face du substrat correspondant aux lames à déposer est réalisé de manière collective par éclairage au travers d'un masque (35) percé d'ouvertures (34) correspondant aux zones à éclairer.

6. Procédé selon l'une quelconque des revendications 1 à 5, caractérisé en ce que le faisceau lumineux est fourni par un laser YAG.

7. Procédé selon l'une quelconque des revendications 1 à 6, caractérisé en ce que le substrat étant en silicium monocristallin, le bombardement est réalisé par des ions hydrogène à une température du substrat comprise entre 150°C et 350°C, le faisceau lumineux portant la zone du substrat éclairé à une température supérieure à 600°C.

8. Application du procédé selon l'une quelconque des revendications 1 à 7 pour la réalisation des transistors de commande des pixels d'un écran plat à matrice active.

9. Application du procédé selon l'une quelconque des revendications 1 à 7 pour la réalisation d'un capteur d'images.

10. Application du procédé selon l'une quelconque des revendications 1 à 7 pour la réalisation de têtes d'impression à matrice active.

## Patentansprüche

1. Abscheidungsverfahren von wenigstens einer Halbleiterschicht bzw. einem Halbleiterstreifen (20) von bestimmter Dicke und Ausdehnung auf einem Träger (10), folgende Schritte umfassend:
- Ionenbeschuß (6) einer Fläche (2) eines Halbleitersubtrats (1), um eine einer Spaltungsebene des Substrats (1) entsprechende Mikrogasblasenschicht (7) zu erzeugen, wobei die Energie der Ionenimplantation vorgesehen wird, um die Mikrogasblasenschicht (7) in einer Tiefe zu erhalten, die der festgelegten Dicke der Halbleiterstreifen (20) entspricht, und die Ionen ausgewählt werden unter den Ionen der Edelgase oder der Wasserstoffgase,
- Erstarrung des Substrats des Trägers (10) auf der genannten Fläche (2),
- Wärmebehandlung, um in der Mikrogasblasenschicht (7) eine Temperatur zu erzeugen, die ausreicht, die Spaltung zu verursachen,
**dadurch gekennzeichnet,**
daß der Wärmebehandlungsschritt mittels eines Lichtbündels durchgeführt wird, das selektiv eine Zone der genannten Fläche des Substrats (1) durch den Träger (10) hindurch beleuchtet, der für dieses Lichtbündel durchlässig ist, um adiabatisch die genannte Temperatur in einem Bereich der Mikrogasblasenschicht zu erzeugen, der dem abzuscheidenden Halbleiterstreifen entspricht, wobei das Lichtbündel auch eine Zunahme der Haftung des Trägers (10) auf der genannten Fläche des Substrats (1) in der besagten, von dem Lichtbündel durchquerten Zone bewirkt, und auf diesen Wärmebehandlungsschritt ein Loslösungsschritt des Substrats (1) von dem Träger (10) folgt, wobei sich bei dieser Loslösung der Streifen (20) vom Substrat trennt und auf dem Träger zurückbleibt, in der genannten Zone.

2. Verfahren nach Anspruch 1, dadurch gekennzeichnet, daß es vor oder nach dem Ionenbeschuß-Schritt einen Ätzschritt gibt, um in der genannten Fläche (2) des Substrats (1) Gräben (3, 4) herzustellen, die auf der Fläche des Substrats eine der Ausdehnung des genannten Streifens entsprechende Fläche begrenzen.

3. Verfahren nach Anspruch 2, dadurch gekennzeichnet, daß die Tiefe der Gräben größer ist als die Tiefe der Mikrogasblasenschicht.

4. Verfahren nach einem der Ansprüche 1 bis 3, dadurch gekennzeichnet, daß, wenn das Substrat (1) dem Träger (10) mehrere Streifen (20) liefern soll, die Beleuchtung der Zonen der den abzuscheidenden Streifen entsprechenden Seite des Substrats durch Abtastung des Substrats mit dem Lichtbündel (11, 12) erfolgt.

5. Verfahren nach einem der Ansprüche 1 bis 3, dadurch gekennzeichnet, daß, wenn das Substrat (1) dem Träger (10) mehrere Streifen (20) liefern soll, die Beleuchtung der Zonen (21, 22) der den abzuscheidenden Streifen entsprechenden Seite des Substrats kollektiv mittels Beleuchtung durch eine Maske (35) hindurch ausgeführt wird, die von Öffnungen (34) durchdrungen ist, die den zu beleuchtenden Zonen entsprechen.

6. Verfahren nach einem der Ansprüche 1 bis 5, dadurch gekennzeichnet, daß das Lichtbündel durch einen YAG-Laser geliefert wird.

7. Verfahren nach einem der Ansprüche 1 bis 6, dadurch gekennzeichnet, daß das Substrat aus monokristallinem Silicium ist, der Beschuß mit Wasserstoffionen bei einer Substrattemperatur zwischen 150°C und 350°C erfolgt und das Lichtbündel die beleuchtete Zone des Substrats auf eine Temperatur von mehr als 600°C bringt.

8. Anwendung des Verfahrens nach einem der Ansprüche 1 bis 7 zur Herstellung von Steuertransistoren der Pixel eines flachen Bildschirms mit aktiver Matrix.

9. Anwendung des Verfahrens nach einem der Ansprüche 1 bis 7 zur Herstellung eines Bildaufnahmesensors.

10. Anwendung des Verfahrens nach einem der Ansprüche 1 bis 7 zur Herstellung von Druckköpfen mit aktiver Matrix.

## Claims

1. Method for the deposition of at least one semiconductor plate (20) of given thickness and size on a support (10) and comprising the following stages:
- bombardment of one face (2) of a semiconductor substrate (1) by ions (6) in order to create a film (7) of gaseous microbubbles in accordance with a splitting or cleaving plane of the substrate (1), the ion implantation energy being provided in order to obtain the film (7) of gaseous microbubbles at a depth corresponding to the given thickness of the semiconductor plate (20), the ions being chosen from among rare gas or hydrogen gas ions,
- rendering integral on said face (2) the substrate of the support (10),
- heating treatment in order to induce an adequate temperature for bringing about said splitting in the film (7) of gaseous microbubbles,
characterized in that the heat treatment stage is performed by means of a luminous beam selectively illuminating an area of said face of the substrate (1), through the support (10) and which is transparent to said luminous beam, in order to adiabatically induce said temperature in a region of the film of gaseous microbubbles corresponding to the semiconductor plate to be deposited, the luminous beam also bringing about an increase in the adhesion of the support (10) to said face of the substrate (1) in said area traversed by the luminous beam, said heat treatment stage being followed by a stage of disengaging the substrate (1) from the support (10), said disengagement separating the plate (20) from the substrate and keeping it on the support in said area.

2. Method according to claim 1, characterized in that it comprises, prior to or subsequent to the bombardment stage, a stage of etching from said face (2) of the substrate (1) trenches (3, 4) delimiting on the face of the substrate a surface corresponding to the size of said plate.

3. Method according to claim 2, characterized in that the depth of the trenches is greater than the depth of the film of gaseous microbubbles.

4. Method according to any one of the claims 1 to 3, characterized in that, as the substrate (1) is required to provide several plates (20) on the support (10), the illumination of the zones of the face of the substrate corresponding to the plates to be deposited is obtained by scanning the substrate with the luminous beam (11, 12).

5. Method according to any one of the claims 1 to 3, characterized in that, as the substrate (1) is needed to provide several plates (20) on the support (10), the illumination of the zones (21, 22) of the face of the substrate corresponding to the plates to be deposited is effected collectively by means of illumination through a mask (35) pierced with openings (34) corresponding to the zones to be illuminated.

6. Method according to any one of the claims 1 to 5, characterized in that the luminous beam is supplied by a YAG laser.

7. Method according to any one of the claims 1 to 6, characterized in that the substrate is made of monocrystalline silicon and bombardment is carried out by hydrogen ions at a temperature of the substrate of between 150°C and 350°C, the luminous beam raising the temperature of the zones of the illuminated substrate to more than 600°C.

8. Application of the method according to any one of the claims 1 to 7 for producing transistors for controlling the pixels of an active matrix flat screen.

9. Application of the method according to any one of the claims 1 to 7 for producing an image sensor.

10. Application of the method according to any one of the claims 1 to 7 for producing active matrix printing heads.
